# EUROPEAN PATENT APPLICATION

(11) **EP 4 671 784 A1**
(43) Date of publication of application: **31.12.2025**
(21) Application number: 23935516.7
(22) Date of filing: 07.11.2023
(51) Int. Cl.: G01R 31/367, G01R 31/396, G01R 31/382, G01R 31/385, G06N 20/00, G06N 3/08

(54) **LEARNING MODEL MONITORING DEVICE AND OPERATING METHOD THEREFOR**

(30) Priority: 28.04.2023 KR 20230056575
(71) Applicant: LG ENERGY SOLUTION, LTD., Seoul 07335 (KR)
(72) Inventor: YIM, In Hyeok, Daejeon 34122 (KR); PARK, Ji Hye, Daejeon 34122 (KR); CHOI, Jee Soon, Daejeon 34122 (KR)
(74) Representative: Plasseraud IP
(86) International application number: PCT/KR2023/017752
(87) International publication number: WO 2024/225543

(57) **Abstract**

A learning model monitoring apparatus according to an embodiment disclosed in this document may include an acquisition unit configured to acquire time series data of a battery, an extraction unit configured to organize the time series data and extract at least one feature value corresponding to at least one feature for each of a plurality of sub-time series data corresponding to different cycles, a learning unit configured to training a state diagnosis model capable of diagnosing the state of the battery based on the extracted at least one feature value, a first importance evaluation unit configured to evaluate local importance of the at least one feature for the trained state diagnosis model in each cycle, and a second importance evaluation unit configured to evaluate global importance of the at least one feature for the trained state diagnosis model based on the local importance.

## Description

### [Technical Field]

### CROSS-REFERENCE TO RELATED APPLICATION

This application claims priority to and the benefit of Korean Patent Application No. 10-2023-0056575 filed in the Korean Intellectual Property Office on April 28, 2023, the entire contents of which are incorporated herein by reference.

### TECHNICAL FIELD

Embodiments disclosed in this document relate to a learning model monitoring apparatus and method.

### [Background Art]

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, Lithium-ion batteries can be manufactured small and lightweight enough to be used as power sources for mobile devices and recently expand their usage range to power sources for electric vehicles, drawing attention as a next-generation energy storage medium.

For the state diagnosis of these batteries, machine learning-based state diagnosis models are being used. A common method of ensuring the explainability of machine learning-based models is to evaluate the importance of features as the input parameters of the model, which facilitates understanding of the model's operating principle.

However, in most cases, a method evaluating the global importance of features for a model trained on battery time series data is employed, but the reliability may decrease when the characteristics of battery data change (e.g., due to changes in the causes of battery abnormalities). There is therefore a need to develop a machine learning-based learning model monitoring system capable of providing not only global explanations for time series data but also local explanations for some data, enabling the development of a reliable learning model that facilitates understanding the result values even when the characteristics of battery data change.

### [Disclosure]

### [Technical Problem]

Embodiments disclosed in this document provide a learning model monitoring apparatus and method capable of evaluating the local importance of features for a state diagnosis learning model for each battery cycle, and evaluating the global importance of the features based on the evaluated local importance.

Embodiments disclosed in this document provide a learning model monitoring apparatus and method capable of evaluating causal relationships among the parameters of a state diagnosis learning model.

The technical objects of the embodiments disclosed in this document are not limited to the aforesaid, and other objects not described herein with be clearly understood by those skilled in the art from the descriptions below.

### [Technical Solution]

A learning model monitoring apparatus according to an embodiment disclosed in this document may include an acquisition unit configured to acquire time series data of a battery, an extraction unit configured to organize the time series data and extract at least one feature value corresponding to at least one feature for each of a plurality of sub-time series data corresponding to different cycles, a learning unit configured to training a state diagnosis model capable of diagnosing a state of the battery based on the extracted at least one feature value, a first importance evaluation unit configured to evaluate local importance of the at least one feature for the trained state diagnosis model in each cycle, and a second importance evaluation unit configured to evaluate global importance of the at least one feature for the trained state diagnosis model based on the local importance.

In a learning model monitoring apparatus according to an embodiment disclosed in this document, the first importance evaluation unit may calculate a Shapley value of the at least one feature for the trained state diagnosis model and evaluate the local importance based on the calculated Shapley value.

In a learning model monitoring apparatus according to an embodiment disclosed in this document, the second importance evaluation unit may evaluate the global importance by averaging a plurality of local importances in the cycles for each of the at least one feature.

A learning model monitoring apparatus according to an embodiment disclosed in this document may further include a causality evaluation unit configured to evaluate a causal relationship between factors of the trained state diagnosis model, wherein the factors may include a state diagnostic result and/or the at least one feature.

In a learning model monitoring apparatus according to an embodiment disclosed in this document, the causality evaluation unit may evaluate a causal relationship between the state diagnostic result and the at least one feature among the factors.

A learning model monitoring apparatus according to an embodiment disclosed in this document may further an analysis unit configured to analyze a relationship between a first feature and a second feature, wherein the causality evaluation unit may determine the second feature causing the first feature with a highest global importance among the at least one feature by evaluating s causal relationship between the at least one features.

In a learning model monitoring apparatus according to an embodiment disclosed in this document, the time series data may include time series data for at least one of voltage, current, or temperature of the battery.

A learning model monitoring apparatus according to an embodiment disclosed in this document may further include a preprocessing unit configured to extract the plurality of sub-time series data by classifying the cycles based on whether the battery is charging or discharging in the time series data.

A learning model monitoring method according to an embodiment disclosed in this document may include acquiring time series data of a battery, organizing the time series data and extracting at least one feature value corresponding to at least one feature for each of a plurality of sub-time series data corresponding to different cycles, training a state diagnosis model capable of diagnosing a state of the battery based on the extracted at least one feature value, evaluating local importance of the at least one feature for the trained state diagnosis model in each cycle, and evaluating global importance of the at least one feature for the trained state diagnosis model based on the local importance.

In a learning model monitoring method according to an embodiment disclosed in this document, the evaluating of the local importance may include calculating a Shapley value of the at least one featured for the trained state diagnosis model and evaluating the local importance based on the calculated Shapley value.

In a learning model monitoring method according to an embodiment disclosed in this document, the evaluating of the global importance may include evaluating the global importance by averaging a plurality of local importances of the cycles for each of the at least one feature.

A learning model monitoring method according to an embodiment disclosed in this document may further include evaluating a causal relationship between factors of the trained state diagnosis model, wherein the factors may include a state diagnostic result and/or the at least one feature.

In a learning model monitoring method according to an embodiment disclosed in this document, the evaluating of the causal relationship may include evaluating a causal relationship between the state diagnostic result and the at least one feature among the factors.

A learning model monitoring method according to an embodiment disclosed in this document may further include analyzing a relationship between a first feature and a second feature, wherein the evaluating of the causal relationship may include determining the second feature causing the first feature with a highest global importance among the at least one feature by evaluating a causal relationship between the at least one features.

A learning model monitoring method according to an embodiment disclosed in this document may further include extracting the plurality of sub-time series data by classifying the cycles based on whether the battery is charging or discharging in the time series data.

### [Advantageous Effects]

According to the embodiments disclosed in this document, it is possible to improve the reliability of the results of the learning model for battery state diagnosis even when battery data characteristics change, by enabling both global explanations for time series data and local explanations for some data of the learning model.

According to the embodiments disclosed in this document, it is possible to confirm the causal relationships among the parameters of the state diagnosis learning model that cannot be confirmed through feature importance evaluation alone.

In addition, various effects identified directly or indirectly through this document can be provided.

### [Description of Drawings]

FIG. 1 is a block diagram illustrating the configuration of a learning model monitoring apparatus according to an embodiment;
FIG. 2 is a block diagram illustrating an evaluation unit in a learning model monitoring apparatus according to an embodiment;
FIG. 3 is a diagram illustrating an example of extracting a plurality of sub-time series data from battery time series data acquired by a learning model monitoring apparatus according to an embodiment;
FIG. 4 is a diagram illustrating an example of extracting a feature value for each of a plurality of sub-time series data at a learning model monitoring apparatus according to an embodiment;
FIG. 5 is a diagram illustrating an example of evaluating the local importance of features for a state diagnosis model for each cycle at a learning model monitoring apparatus according to an embodiment;
FIG. 6 shows graphs representing local importance and global importance evaluated by a learning model monitoring apparatus according to an embodiment;
FIG. 7 is a diagram illustrating an example of evaluating causal relationships among parameters of a state diagnosis model at a learning model monitoring apparatus according to an embodiment;
FIG. 8 is a flowchart illustrating operations of a learning model monitoring apparatus according to an embodiment;
FIG. 9 is a flowchart illustrating operations of a learning model monitoring apparatus according to an embodiment;
FIG. 10 is a flowchart illustrating operations of a learning model monitoring apparatus according to an embodiment; and
FIG. 11 is a flowchart illustrating operations of a learning model monitoring apparatus according to an embodiment.

### [Mode for Invention]

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

Various embodiments disclosed in this document and terms used therein are not intended to limit the technical features described in this document to specific embodiments, and the disclosure should be construed as including various modifications, equivalents, and/or alternatives of the corresponding embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (e.g., importance or order) unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired), wirelessly, or via a third component.

According to various embodiments, each component (e.g., module or program) of the components described above may include a single object or a plurality of objects, and some of the multiple objects may be separately disposed in other components. According to various embodiments, one or more components or operations among the aforementioned components may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

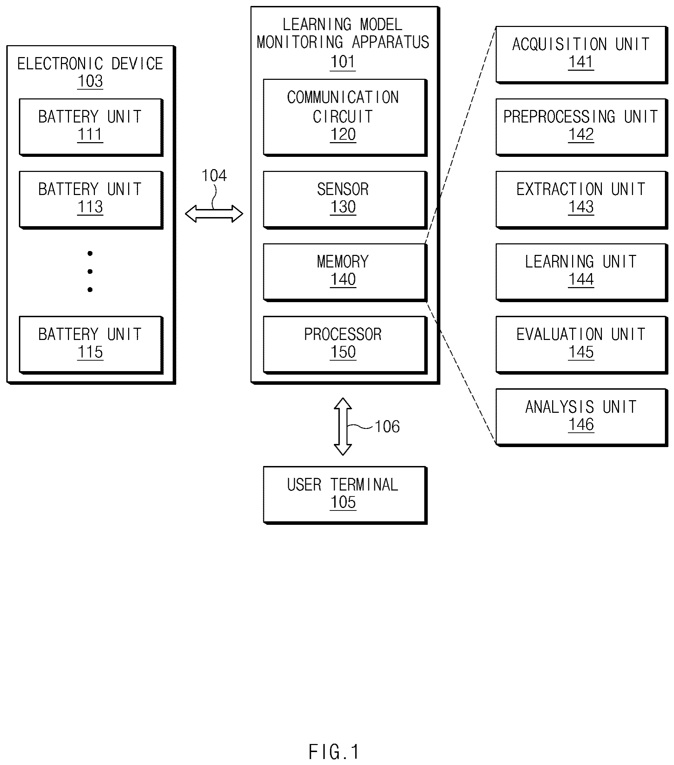

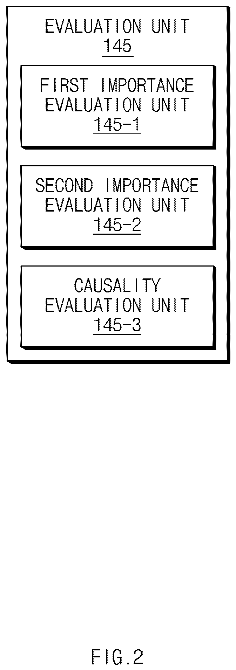

Hereinafter, descriptions are made of the configurations of a data processing apparatus with reference to FIGS. 1 and 2.

FIG. 1 is a block diagram illustrating the configuration of a learning model monitoring apparatus according to an embodiment. FIG. 2 is a block diagram illustrating an evaluation unit in a learning model monitoring apparatus according to an embodiment.

With reference to FIG. 1, the learning model monitoring apparatus 101 may be connected to an electronic device 103 and a user terminal 105 through a wired and/or wireless connection.

According to an embodiment, the connection 104 between the learning model monitoring apparatus 101 and the electronic device 103 may be a communication link established through wired and/or wireless networks. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network encompassing 4^{th} Generation (4G) and 5G network networks).

According to another embodiment, the connection 104 between the learning model monitoring apparatus 101 and the electronic device 103 may be a connection established through an inter-device communication interface (e.g., bus, general purpose input and output (GPIO), serial peripheral interface (SPI), or mobile industry processor interface (MIPI)).

According to an embodiment, the connection 106 between the learning model monitoring apparatus 101 and the user terminal 105 may be a connection link established through wired and/or wireless networks.

According to an embodiment, the electronic device 103 may be a mobile device (e.g., portable phone, laptop computer, smartphone, and smart pad), an electrified vehicle (e.g., electric vehicle (EV), hybrid EV (HEV), plug-in HEV (PHEV), and fuel cell EV (FCEV), an energy storage system (ESS), or a battery swapping system (BSS).

According to an embodiment, the electronic device 103 may include one or more battery units 111, 113, and 115. Each of the one or more battery units 111, 113, and 115 may be a battery cell, battery module, battery pack, or battery rack.

According to an embodiment, the user terminal 105 may be a mobile device (e.g., portable phone, laptop computer, smartphone, and smart pad) or a personal computer (PC).

According to an embodiment, the learning model monitoring apparatus 101 may include a communication circuit 120, a sensor 130, a memory 140, and a processor 150. According to an embodiment, the learning model monitoring apparatus 101 shown in FIG. 1 may further include at least one additional component (e.g., a display, input device, or output device) other than the components illustrated in FIG. 1.

According to an embodiment, the communication circuit 120 may establish a wired and/or wireless communication channel between the learning model monitoring apparatus 101 and the electronic device 103 and/or user terminal 105 and exchange data with the electronic device 103 and/or the user terminal 105 through the established communication channel.

According to an embodiment, the sensor 130 may acquire values related to the state of the battery units 111, 113, and 115 of the electronic device 103. In an embodiment, the values related to the state may include one or more values representing the voltage, current, resistance, state of charge (SOC), state of health (SOH), or temperature of the battery units 111, 113, and 115, or any combination thereof. In the following, a value related to a state may be referred to as a state value.'

According to an embodiment, the memory 140 may include volatile memory and/or non-volatile memory.

According to an embodiment, the memory 140 may store data used by at least one component of the learning model monitoring apparatus 101 (e.g., processor 150). For example, the data may include software (or related instructions), input data, or output data. In an embodiment, the instructions may be executed by the processor 150 for the battery abnormality diagnosis apparatus 101 to perform operations defined by the instructions.

According to an embodiment, the memory 140 may include one or more software components (e.g., acquisition unit 141, preprocessing unit 142, extraction unit 143, learning unit 144, evaluation unit 145, and analysis unit 146).

With reference to FIG. 2, the evaluation unit 145 may include a first importance evaluation unit 145-1, a second importance evaluation unit 145-2, and/or a causality evaluation unit 145-3.

With reference to FIG. 1 again, the processor 150 may include a central processing unit, application processor, graphics processing unit, neural processing unit (NPU), image signal processor, sensor hub processor, or communication processor.

According to an embodiment, the processor 150 may execute software (e.g., acquisition unit 141, preprocessing unit 142, extraction unit 143, learning unit 144, evaluation unit 145, and analysis unit 146) to control at least one other component (e.g., hardware or software component) connected to the processor 150 in the learning model monitoring apparatus 101 and perform various data processing or computations.

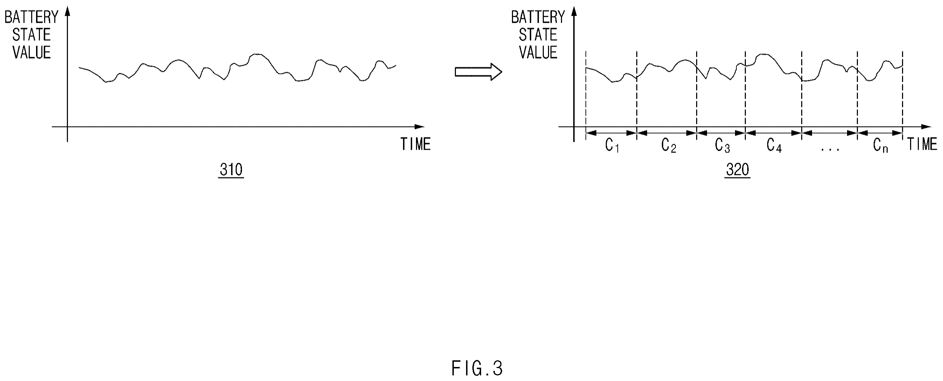

Hereinafter, a description is made of the method for the learning model monitoring apparatus 101 to monitor a state diagnosis model capable of diagnosing the state of the battery 111, 113, or 115 through the acquisition unit 141, preprocessing unit 142, extraction unit 143, learning unit 144, evaluation unit 145, and analysis unit 146, with reference to FIGS. 3 to 7.

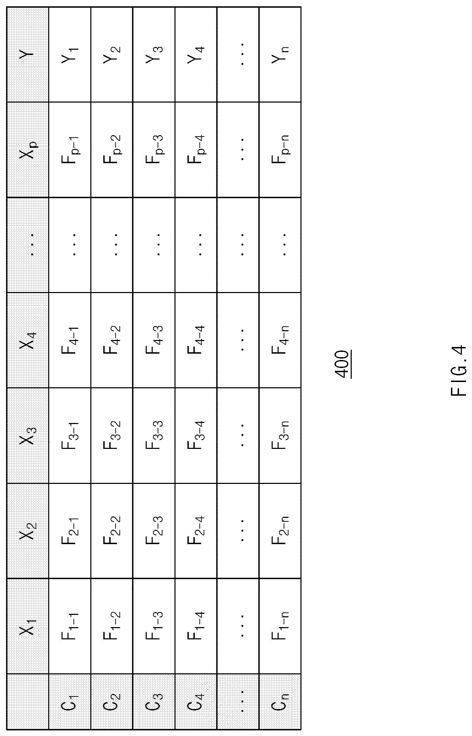

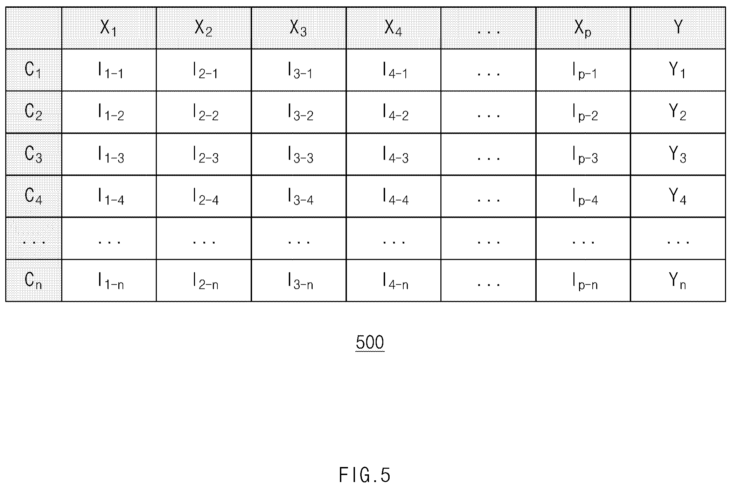

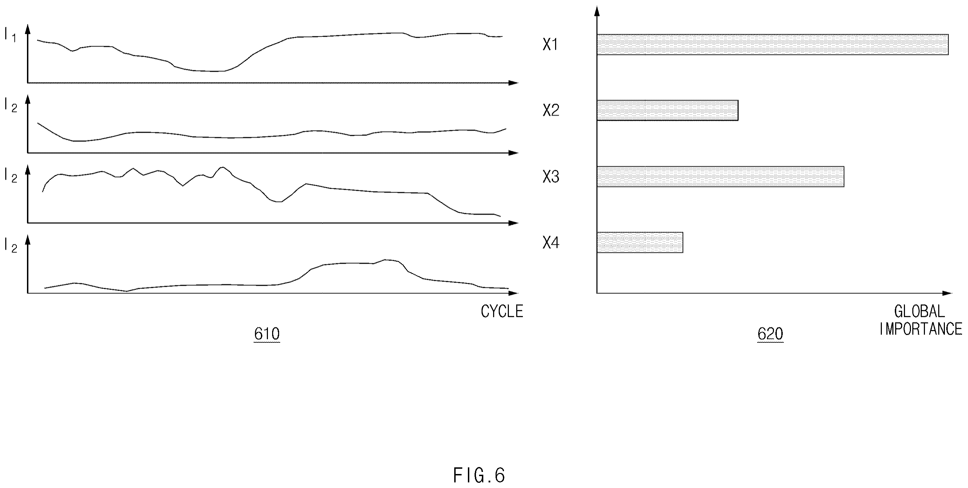

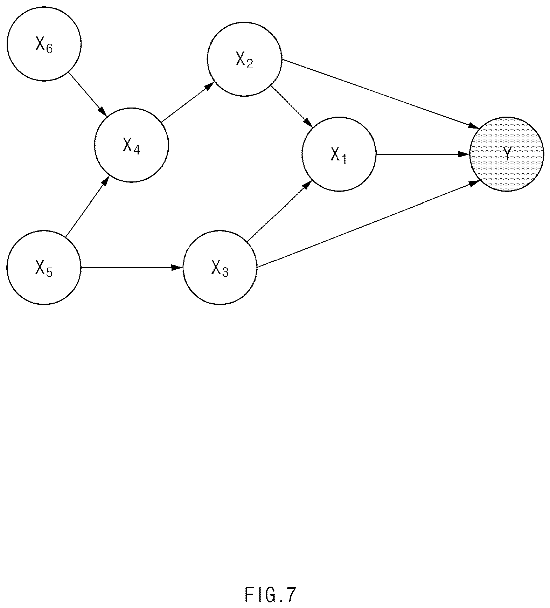

FIG. 3 is a diagram illustrating an example of extracting a plurality of sub-time series data from battery time series data acquired by a learning model monitoring apparatus according to an embodiment; FIG. 4 is a diagram illustrating an example of extracting a feature value for each of a plurality of sub-time series data at a learning model monitoring apparatus according to an embodiment; FIG. 5 is a diagram illustrating an example of evaluating the local importance of features for a state diagnosis model for each cycle at a learning model monitoring apparatus according to an embodiment. FIG. 6 shows graphs representing local importance and global importance evaluated by a learning model monitoring apparatus according to an embodiment. FIG. 7 is a diagram illustrating an example of evaluating causal relationships among parameters of a state diagnosis model at a learning model monitoring apparatus according to an embodiment.

FIG. 3 shows graphs 310 and 320 representing time series data of a battery 111, 113, or 115.

According to an embodiment, the acquisition unit 141 may acquire the time series data of the battery 111, 113, or 115 as shown in graph 310. Here, the time series data may include data for at least one of the voltage, current, or temperature of the battery 111, 113, or 115. Therefore, the y-axis of the graphs 310 and 320 may represent the state values (voltage, current, or temperature) of the battery 111, 113, or 115.

According to an embodiment, the preprocessing unit 142 may extract a plurality of sub-time series data from the time series data. Here, the time series data may be composed of the plurality of sub-time series data. In an embodiment, the preprocessing unit 142 may classify cycles C₁, C₂, C₃, C₄, ..., and Cₙ of the battery 111, 113, or 115 based on whether the battery is charging or discharging, as shown in the graph 320. Here, the cycles C₁, C₂, C₃, C₄, ..., and Cₙ may include different charging phases, discharging phases, and rest phases. The preprocessing unit 142 may extract a plurality of sub-time series data corresponding to the cycles C₁, C₂, C₃, C₄, ..., and Cₙ, respectively. For example, the preprocessing unit 142 may extract the first sub-time series data representing the battery state value in the first cycle C₁, the second sub-time series data representing the battery state value in the second cycle C₂, the third sub-time series data representing the battery state value in the third cycle C₃, the fourth sub-time series data representing the battery state value in the fourth cycle C₄, and the nth sub-time series data representing the battery state value in the n^{th} cycle Cₙ.

According to an embodiment, the extraction unit 143 may organize the time series data and extract at least one feature value for each of the plurality of sub-time series data corresponding to the respective cycles. According to an embodiment, the extraction unit 143 may set at least one feature related to the battery state value (e.g., average value, maximum value, minimum value, slope, standard deviation, standard score, etc.). The extraction unit 143 may extract at least one feature value corresponding to at least one feature for each of the plurality of sub-time series data.

With reference to FIG. 4, the extraction unit 143 may configure a plurality of features X₁, X₂, X₃, X₄, ..., Xₚ. In an embodiment, the extraction unit 143 may extract a plurality of feature values corresponding to the plurality of features X₁, X₂, X₃, X₄, ..., Xₚ for each of the plurality of sub-time series data corresponding to the plurality of cycles C₁, C₂, C₃, C₄, ..., and Cₙ. As an example, the extraction unit 143 may extract a plurality of feature values F₁₋₁, F₂₋₁, F₃₋₁, F₄₋₁, ..., Fₚ₋₁ corresponding to the plurality of features X₁, X₂, X₃, X₄, ..., Xₚ based on the first sub-time series data corresponding to the first cycle C₁, as shown in the dataset 400.

For example, the first feature X₁ may represent the average value of the battery state values, the second feature X₂ may represent the maximum value of the battery state values, the third feature X₃ may represent the minimum value of the battery state values, the fourth feature X₄ may represent the slope of the battery state values, and the p^{th} feature Xₚ may represent the standard deviation of the battery state values. In this case, the extraction unit 143 may extract the average value of the battery state values as the first-1 feature value F₁₋₁, the maximum value of the battery state values as the second-1 feature value F₂₋₁, the minimum value of the battery state values as the third-1 feature value F₃₋₁, the slope of the battery state values as the fourth-1 feature value F₄₋₁, and the standard deviation of the battery state values as the p^{th}-1 feature value Fₚ₋₁, based on the first cycle C₁, based on the first sub-time series data. The extraction unit 143 may extract a plurality of feature values F₁₋₁, F₂₋₁, F₃₋₁, F₄₋₁, ..., Fₚ₋ₙ from the plurality of sub-time series data corresponding to the plurality of cycles C₁, C₂, C₃, C₄, ..., and Cₙ.

According to an exemplary embodiment, the learning unit 144 may train a state diagnosis model capable of diagnosing the state of the battery 111, 113, or 115 based on at least one feature value extracted by the extraction unit 143. Here, the state diagnosis model may be a machine learning-based learning model that outputs the state diagnostic results of the battery 111, 113, or 115 based on input parameters related to the state values of the battery.

In an embodiment, the learning unit 144 may train the state diagnosis model based on the state diagnostic results of the battery 111, 113, or 115 for each cycle in addition to at least one feature value. For example, the learning unit 144 may train the state diagnosis model based on the dataset 400 of FIG. 4. The state diagnostic results Y₁, Y₂, Y₃, Y₄, ..., Yₙ for each cycle in the dataset 400 may be the results pre-diagnosed by the electronic device 103 or pre-diagnosed by the learning model monitoring apparatus 101 based on the plurality of sub-time series data. According to an embodiment, the state diagnosis model may learn the relationship between the plurality of feature values and the diagnostic results for each cycle. For example, the state diagnosis model may learn the relationship between plurality of feature values F₁₋₁, F₂₋₁, F₃₋₁, F₄₋₁, ..., Fₚ₋₁ in the first cycle C1 and the first diagnostic result Y₁.

In an embodiment, the first importance evaluation unit 145-1 may evaluate the local importance of at least one feature for each cycle, based on the state diagnosis model trained by the learning unit 144.

With reference to FIG. 5, the first importance evaluation unit 145-1 may evaluate the local importances I₁₋₁, I₂₋₁, I₃₋₁, I₄₋₁, ..., and Iₚ₋ₙ of the plurality of features X₁, X₂, X₃, X₄, ..., and Xₚ for each of the plurality of cycles C₁, C₂, C₃, C₄, ..., and Cₙ, as shown in the dataset 500. Here, the local importance may mean the impact that a specific feature X1, X2, X3, X4, ..., or Xp has on the diagnostic performance of the state diagnosis model within a specific cycle C1, C2, C3, C4, ..., or Cn.

In an exemplary embodiment, the first importance evaluation unit 145-1 may analyze the process in which the state diagnosis model learns the relationship between the plurality of feature values F₁₋₁, F₂₋₁, F₃₋₁, F₄₋₁, ..., Fₚ₋₁ in the first cycle C1 and the first diagnostic result Y₁ or analyze the state diagnosis model learned the relationship. The first importance evaluation unit 145-1 may evaluate the local importance I₁₋₁, I₂₋₁, I₃₋₁, I₄₋₁, ..., Iₚ₋₁ for each of the plurality of features X₁, X₂, X₃, X₄, ..., Xₚ based on the analysis. For example, the first importance evaluation unit 145-1 may calculate the Shapley value for each of the plurality of features X₁, X₂, X₃, X₄, ..., Xₚ based on the analysis. The first importance evaluation unit 145-1 may evaluate the local importance values I₁₋₁, I₂₋₁, I₃₋₁, I₄₋₁, ..., Iₚ₋₁ for each of the plurality of features X₁, X₂, X₃, X₄, ..., Xₚ based on the calculated Shapley values. Here, the first importance evaluation unit 145-1 may determine the Shapley values as the local importance values I₁₋₁, I₂₋₁, I₃₋₁, I₄₋₁, ..., Iₚ₋₁. The first importance evaluation unit 145-1 may evaluate the local importances I₁₋₁, I₂₋₁, I₃₋₁, I₄₋₁, ..., and Iₚ₋ₙ of the plurality of features X₁, X₂, X₃, X₄, ..., and Xₚ for each of the plurality of cycles C₁, C₂, C₃, C₄, ..., and Cₙ in the same manner as described above.

In an embodiment, the second importance evaluation unit 145-2 may evaluate the global importance of at least one feature for the state diagnosis model trained by the learning unit 144 based on the local importance evaluated by the first importance evaluation unit 145-1.

According to an embodiment, the second importance evaluation unit 145-2 may evaluate the global importance of the plurality of features X₁, X₂, X₃, X₄, ..., and Xₚ for the state diagnosis model by averaging the plurality of local importance values I₁₋₁, I₂₋₁, I₃₋₁, I₄₋₁, ..., Iₚ₋ₙ in the plurality of cycles C₁, C₂, C₃, C₄, ..., and Cₙ. Here, the global importance may mean the impact that a specific feature X₁, X₂, X₃, X₄, ..., or Xₚ has on the diagnostic performance of the state diagnosis model across all cycle C₁, C₂, C₃, C₄, ..., or Cₙ.

For example, the second importance evaluation unit 145-2 may evaluate the global importance of the first feature X₁ by averaging the plurality of local importance values I₁₋₁, I₁₋₂, I₁₋₃, I₁₋₄, ..., I₁₋ₙ across plurality of cycles C₁, C₂, C₃, C₄, ..., and Cₙ. As another example, the second importance evaluation unit 145-2 may evaluate the global importance of the second feature X₂ by averaging the plurality of local importance values I₂₋₁, I₂₋₂, I₂₋₃, I₂₋₄, ..., I₂₋ₙ across the plurality of cycles C₁, C₂, C₃, C₄, ..., and Cₙ. The second importance evaluation unit 145-2 may evaluate the global importance of multiple features X₁, X₂, X₃, X₄, ..., and Xₚ in the same manner as described above.

With reference to FIG. 6, the learning model monitoring apparatus 101 may display the trend of local importance for each of the features evaluated by the first importance evaluation unit 145-1 in a graph 610. In addition, the learning model monitoring apparatus 101 may display the global importance of the features evaluated by the second importance evaluation unit 145-2 in a graph 620. For example, the learning model monitoring apparatus 101 may display the graphs 610 and/or 620 through at least one component (e.g., display or output device) included in the learning model monitoring apparatus or an external device.

In an embodiment, the causality evaluation unit 145-3 may evaluate the causal relationships between factors in the state diagnosis model trained by the learning unit 144. Here, the factors may include the state diagnostic results of the battery 111, 113, or 115 and/or at least one feature. For example, the state diagnostic results may be the diagnostic results Y included in the dataset of FIG. 4 (or FIG. 5), and at least one feature may be the plurality of features X₁, X₂, X₃, X₄, ..., and Xₚ included in the dataset of FIG. 4 (or FIG. 5).

In an embodiment, the causality evaluation unit 145-3 may evaluate the causal relationships between factors using a causal discovery algorithm. Here, the causal discovery algorithm may encompass various algorithms, such as a constraint-based causal discovery algorithm, score-based causal discovery algorithm, and continuous optimization method that derive the causal relationships between learning model factors.

With reference to FIG. 7, the causality evaluation unit 145-3 may evaluate the causal relationships between the factors X₁, X₂, X₃, X₄, X₅, and Y of the state diagnosis model trained by the learning unit 144.

In an embodiment, the causality evaluation unit 145-3 may evaluate the causal relationships between the state diagnostic results and at least one feature. For instance, as shown in FIG. 7, the causality evaluation unit 145-3 may evaluate the first feature X1, the second feature X2, and the third feature X3 as factors causing the state diagnostic result Y.

In one embodiment, the causality evaluation unit 145-3 may evaluate the causal relationships among at least one feature. For example, as shown in FIG. 7, the causality evaluation unit 145-3 may evaluate the second feature X₂ and the third feature X₃ as factors causing the first feature X₁, the fourth feature X₄ as a factor causing the second feature X₂, the fifth feature X₅ as a factor causing the third feature X₃, and the fifth feature X₅ and the sixth feature X₆ as factors causing the first feature X₄.

In an embodiment, the learning model monitoring apparatus 101 may display the evaluated causal relationships through at least one component (e.g., display or output device) included in the learning model monitoring apparatus 101 or an external device.

In an embodiment, the analysis unit 146 may analyze the relationships among the features (e.g., second feature X₂ and/or third feature X₃) causing the feature with the highest global importance among the at least one feature based on the causal relationship evaluated by the causality evaluation unit 145-3. For example, the analysis unit 146 may quantitatively analyze the trend of changes in the first feature X₁ based on numerical changes in the second feature X₂ and/or the third feature X₃.

In an embodiment, the learning model monitoring apparatus 101 may display the analysis by the analysis unit 146 through at least one component (e.g., display or output device) included in the learning model monitoring apparatus 101 or an external device.

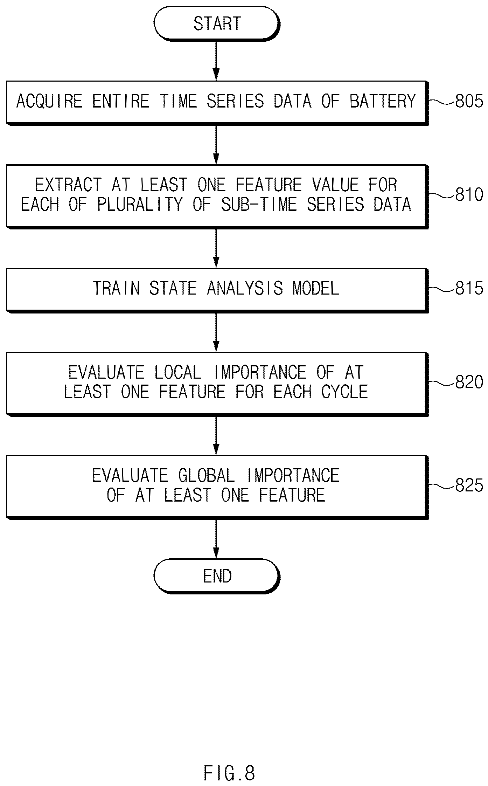

FIG. 8 is a flowchart illustrating operations of a learning model monitoring apparatus according to an embodiment. FIG. 8 may illustrate the operation of the learning model monitoring apparatus 101 in FIG. 1, and descriptions may be made on the basis of the configuration (e.g., learning model monitoring apparatus 101) in FIG. 1.

The embodiment shown in FIG. 8 is merely one embodiment, and the order of operations according to various embodiments of the present invention may be different from that shown in FIG. 8, and some operations shown in FIG. 8 may be omitted, changed in order, or merged.

With reference to FIG. 8, the learning model monitoring apparatus 101 may acquire time series data of the battery 111, 113, or 115 in operation 805. Here, the time series data may include data for at least one of the voltage, current, or temperature of the battery 111, 113, or 115.

In operation 810, the learning model monitoring apparatus 101 may extract at least one feature value for each of the plurality of sub-time series data. Here, the plurality of sub-time series data may constitute the time series data and correspond to different cycles. In an embodiment, the learning model monitoring apparatus 101 may configure at least one feature related to the battery state values (e.g., the average value, maximum value, minimum value, slope, standard deviation, and standard score of the battery state values). The learning model monitoring apparatus 101 may extract at least one feature value corresponding to at least one feature for each of the plurality of sub-time series data.

In operation 815, the learning model monitoring apparatus 101 may train a state diagnosis model capable of diagnosing the state of the battery 111, 113, or 115 based on at least one feature value extracted in operation 810. Here, the state diagnosis model may be a machine learning-based learning model that outputs the state diagnostic results of the battery 111, 113, or 115 based on input parameters related to the state values of the battery.

In an embodiment, the learning model monitoring apparatus 101 may train the state diagnosis model based on the state diagnostic results of the battery 111, 113, or 115 for each cycle in addition to at least one feature value. The state diagnostic results of the battery 111, 113, or 115 for each cycle may be the results pre-diagnosed by the electronic device 103 or pre-diagnosed by the learning model monitoring apparatus 101 based on the plurality of sub-time series data. According to an embodiment, the state diagnosis model may learn the relationship between at least one feature value and the diagnostic results for each cycle.

In operation 820, the learning model monitoring apparatus 101 may evaluate the local importance of at least one feature for each cycle in the state diagnosis model trained in operation 815. Here, each local importance may represent the impact of a specific feature within a specific cycle on the diagnostic performance of the state diagnosis model.

In an embodiment, the learning model monitoring apparatus 101 may analyze the process in which the state diagnosis model learns the relationship between at least one feature value and the battery diagnostic result in a specific cycle or analyze the state diagnosis model learned the relationship. The learning model monitoring apparatus 101 may evaluate the local importance of each of the at least one feature in the specific cycle based on the analysis. For example, the learning model monitoring apparatus 101 may calculate Shapley values for each of the at least one feature based on the analysis. The learning model monitoring apparatus 101 may evaluate the local importance of each of the at least one feature based on the calculated Shapley values. Here, the learning model monitoring apparatus 101 may determine the Shapley values as the local importance.

In operation 825, the learning model monitoring apparatus 101 may evaluate the global importance of at least one feature for the state diagnosis model trained in operation 815 based on the local importance evaluated in operation 820. Here, the global importance may mean the impact that a specific feature has on the diagnostic performance of the state diagnosis model across all cycles.

According to an embodiment, the learning model monitoring apparatus 101 may evaluate the global importance of at each of the at least one feature for the state diagnosis model by averaging at least one local importance for each feature across the plurality of cycles.

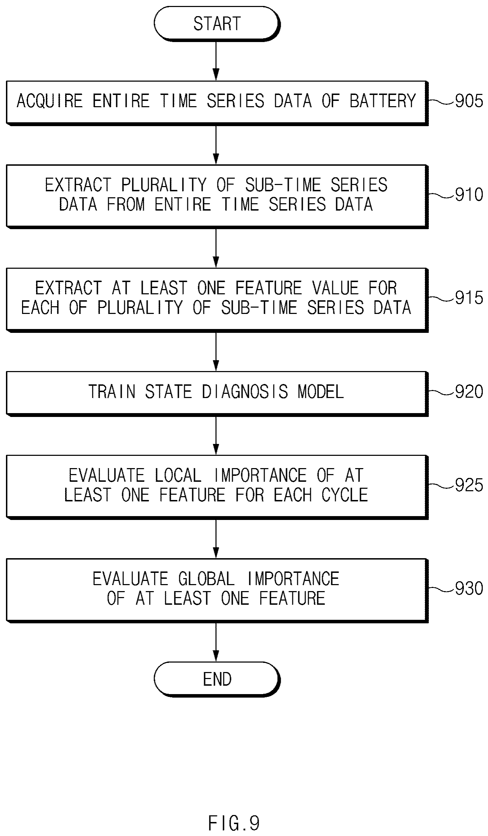

FIG. 9 is a flowchart illustrating operations of a learning model monitoring apparatus according to an embodiment. FIG. 9 may illustrating the operation of the learning model monitoring apparatus 101 in FIG. 1, and descriptions may be made on the basis of the configuration (e.g., learning model monitoring apparatus 101) in FIG. 1.

The embodiment shown in FIG. 9 is merely one embodiment, and the order of operations according to various embodiments of the present invention may be different from that shown in FIG. 9, and some operations shown in FIG. 9 may be omitted, changed in order, or merged.

With reference to FIG. 9, the learning model monitoring apparatus 101 may acquire time series data of the battery 111, 113, or 115 in operation 905. Here, the time series data may include data for at least one of the voltage, current, or temperature of the battery 111, 113, or 115.

In operation 910, the learning model monitoring apparatus 101 may extract a plurality of sub-time series data from the time series data. Here, the time series data may be composed of the plurality of sub-time series data. In an embodiment, the learning model monitoring apparatus 101 may classify the cycles based on whether the battery 111, 113, or 115 is charging or discharging in the time series data. Here, the cycles may include different charging phases, discharging phases, and rest phases. The learning model monitoring apparatus 101 may extract a plurality of sub-time series data corresponding to the respective cycles.

In operation 915, the learning model monitoring apparatus 101 may extract at least one feature value for each of the plurality of sub-time series data extracted in operation 910. In an embodiment, the learning model monitoring apparatus 101 may configure at least one feature related to the battery state values (e.g., the average value, maximum value, minimum value, slope, standard deviation, and standard score of the battery state values). The learning model monitoring apparatus 101 may extract at least one feature value corresponding to at least one feature for each of the plurality of partial time series data.

In operation 920, the learning model monitoring apparatus 101 may train a state diagnosis model capable of diagnosing the state of the battery 111, 113, or 115 based on at least one feature value extracted in operation 810. Here, the state diagnosis model may be a machine learning-based learning model that outputs the state diagnostic results of the battery 111, 113, or 115 based on input parameters related to the state values of the battery.

In an embodiment, the learning model monitoring apparatus 101 may train the state diagnosis model based on the state diagnostic results of the battery 111, 113, or 115 for each cycle in addition to at least one feature value. The state diagnostic results of the battery 111, 113, or 115 for each cycle may be the results pre-diagnosed by the electronic device 103 or pre-diagnosed by the learning model monitoring apparatus 101 based on the plurality of sub-time series data. According to an embodiment, the state diagnosis model may learn the relationship between at least one feature value and the diagnostic results for each cycle.

In operation 925, the learning model monitoring apparatus 101 may evaluate the local importance of at least one feature for each cycle in the state diagnosis model trained in operation 920. Here, each local importance may represent the impact of a specific feature within a specific cycle on the diagnostic performance of the state diagnosis model.

In an embodiment, the learning model monitoring apparatus 101 may analyze the process in which the state diagnosis model learns the relationship between at least one feature value and the battery diagnostic result in a specific cycle or analyze the state diagnosis model learned the relationship. The learning model monitoring apparatus 101 may evaluate the local importance of each of the at least one feature in the specific cycle based on the analysis. For example, the learning model monitoring apparatus 101 may calculate Shapley values for each of the at least one feature based on the analysis. The learning model monitoring apparatus 101 may evaluate the local importance of each of the at least one feature based on the calculated Shapley values. Here, the learning model monitoring apparatus 101 may determine the Shapley values as the local importance.

In operation 930, the learning model monitoring apparatus 101 may evaluate the global importance of at least one feature for the state diagnosis model trained in operation 920 based on the local importance evaluated in operation 925. Here, the global importance may mean the impact that a specific feature has on the diagnostic performance of the state diagnosis model across all cycles.

According to an embodiment, the learning model monitoring apparatus 101 may evaluate the global importance of at each of the at least one feature for the state diagnosis model by averaging at least one local importance for each feature across the plurality of cycles.

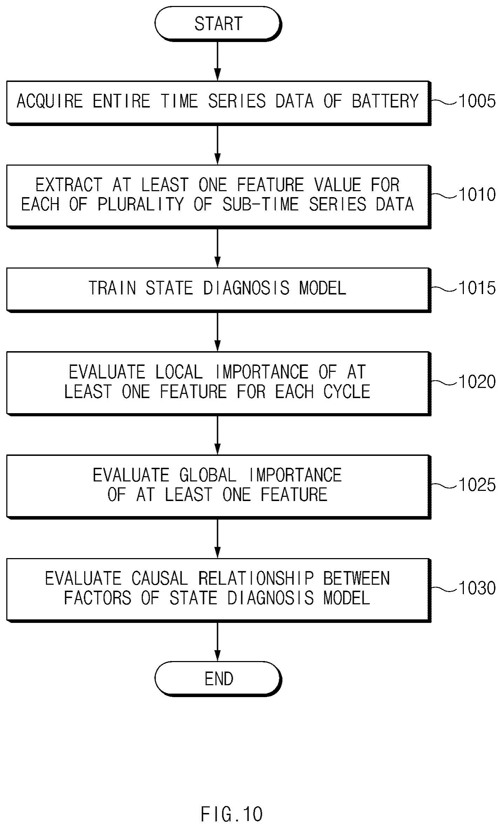

FIG. 10 is a flowchart illustrating operations of a learning model monitoring apparatus according to an embodiment. FIG. 10 may illustrate the operation of the learning model monitoring apparatus 101 in FIG. 1, and descriptions may be made on the basis of the configuration (e.g., learning model monitoring apparatus 101) in FIG. 1.

The embodiment shown in FIG. 10 is merely one embodiment, and the order of operations according to various embodiments of the present invention may be different from that shown in FIG. 10, and some operations shown in FIG. 10 may be omitted, changed in order, or merged.

With reference to FIG. 10, the learning model monitoring apparatus 101 may acquire time series data of the battery 111, 113, or 115 in operation 1005. Here, the time series data may include data for at least one of the voltage, current, or temperature of the battery 111, 113, or 115.

In operation 1010, the learning model monitoring apparatus 101 may extract at least one feature value for each of the plurality of sub-time series data. Here, the plurality of sub-time series data may constitute the time series data and correspond to different cycles. In an embodiment, the learning model monitoring apparatus 101 may configure at least one feature related to the battery state values (e.g., the average value, maximum value, minimum value, slope, standard deviation, and standard score of the battery state values). The learning model monitoring apparatus 101 may extract at least one feature value corresponding to at least one feature for each of the plurality of sub-time series data.

In operation 1015, the learning model monitoring apparatus 101 may train a state diagnosis model capable of diagnosing the state of the battery 111, 113, or 115 based on at least one feature value extracted in operation 1010. Here, the state diagnosis model may be a machine learning-based learning model that outputs the state diagnostic results of the battery 111, 113, or 115 based on input parameters related to the state values of the battery.

In an embodiment, the learning model monitoring apparatus 101 may train the state diagnosis model based on the state diagnostic results of the battery 111, 113, or 115 for each cycle in addition to at least one feature value. The state diagnostic results of the battery 111, 113, or 115 for each cycle may be the results pre-diagnosed by the electronic device 103 or pre-diagnosed by the learning model monitoring apparatus 101 based on the plurality of sub-time series data. According to an embodiment, the state diagnosis model may learn the relationship between at least one feature value and the diagnostic results for each cycle.

In operation 1020, the learning model monitoring apparatus 101 may evaluate the local importance of at least one feature for each cycle in the state diagnosis model trained in operation 1015. Here, each local importance may represent the impact of a specific feature within a specific cycle on the diagnostic performance of the state diagnosis model.

In an embodiment, the learning model monitoring apparatus 101 may analyze the process in which the state diagnosis model learns the relationship between at least one feature value and the battery diagnostic result in a specific cycle or analyze the state diagnosis model learned the relationship. The learning model monitoring apparatus 101 may evaluate the local importance of each of the at least one feature in the specific cycle based on the analysis. For example, the learning model monitoring apparatus 101 may calculate Shapley values for each of the at least one feature based on the analysis. The learning model monitoring apparatus 101 may evaluate the local importance of each of the at least one feature based on the calculated Shapley values. Here, the learning model monitoring apparatus 101 may determine the Shapley values as the local importance.

In operation 1025, the learning model monitoring apparatus 101 may evaluate the global importance of at least one feature for the state diagnosis model trained in operation 1015 based on the local importance evaluated in operation 1020. Here, the global importance may mean the impact that a specific feature has on the diagnostic performance of the state diagnosis model across all cycles.

According to an embodiment, the learning model monitoring apparatus 101 may evaluate the global importance of at each of the at least one feature for the state diagnosis model by averaging at least one local importance for each feature across the plurality of cycles.

In operation 1030, the learning model monitoring apparatus 101 may evaluate the causal relationship between the factors of the state diagnosis model trained in operation 1015. Here, the factors may include the state diagnostic results of the battery 111, 113, or 115 and/or at least one feature.

In an embodiment, the learning model monitoring apparatus 101 may evaluate the causal relationships between factors using a causal discovery algorithm. Here, the causal discovery algorithm may encompass various algorithms, such as a constraint-based causal discovery algorithm, score-based causal discovery algorithm, and continuous optimization method that derive the causal relationships between learning model factors.

In an embodiment, the learning model monitoring apparatus 101 may evaluate the causal relationships between the state diagnostic results and at least one feature among the factors. For example, the learning model monitoring apparatus 101 may evaluate the first feature X₁, the second feature X₂, and the third feature X₃ as factors causing the state diagnostic result Y, as shown in FIG. 7.

In an embodiment, the learning model monitoring apparatus 101 may evaluate the causal relationships among at least one feature. For example, the learning model monitoring apparatus 101 may evaluate the second feature X₂ and the third feature X₃ as factors causing the first feature X₁, the fourth feature X₄ as a factor causing the second feature X₂, the fifth feature X₅ as a factor causing the third feature X₃, and the fifth feature X₅ and the sixth feature X₆ as factors causing the first feature X₄, as shown in FIG. 7.

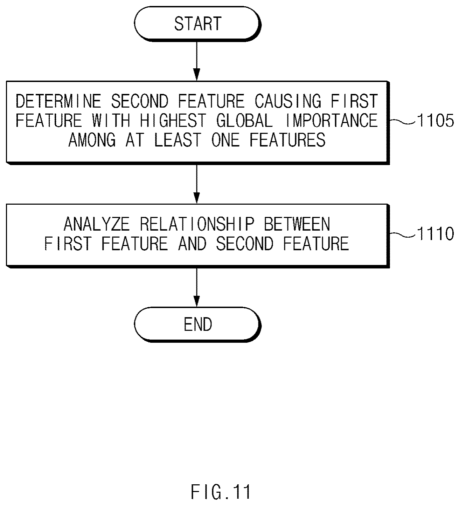

FIG. 11 is a flowchart illustrating operations of a learning model monitoring apparatus according to an embodiment. FIG. 11 may illustrate the operation of the learning model monitoring apparatus 101 in FIG. 1, and descriptions may be made on the basis of the configuration (e.g., learning model monitoring apparatus 101) in FIG. 1.

The embodiment shown in FIG. 11 is merely one embodiment, and the order of operations according to various embodiments of the present invention may be different from that shown in FIG. 11, and some operations shown in FIG. 11 may be omitted, changed in order, or merged.

With reference to FIG. 11, the learning model monitoring apparatus 101 may determine the second feature causing the first feature with the highest global importance among at least one feature in operation 1105. The learning model monitoring apparatus 101 may determine first feature and the second feature based on the global importance evaluation of operation 1025 and the causal relationship evaluation of operation 1030 in FIG. 10.

In operation 1110, the learning model monitoring apparatus 101 may analyze the relationship between the first and second features determined in operation 1105. For example, the learning model monitoring apparatus 101 may quantitatively analyze the trend of changes in the first feature based on numerical changes of the second feature.

Also, the terms such as "comprise", "include", or "have" used above implies that the corresponding component may be present unless otherwise stated specifically, and thus it should be construed as being able to further include other components rather than exclude other components. Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

## Claims

1. A learning model monitoring apparatus comprising:
an acquisition unit configured to acquire time series data of a battery;
an extraction unit configured to organize the time series data and extract at least one feature value corresponding to at least one feature for each of a plurality of sub-time series data corresponding to different cycles;
a learning unit configured to training a state diagnosis model capable of diagnosing a state of the battery based on the extracted at least one feature value;
a first importance evaluation unit configured to evaluate local importance of the at least one feature for the trained state diagnosis model in each cycle; and
a second importance evaluation unit configured to evaluate global importance of the at least one feature for the trained state diagnosis model based on the local importance.

2. The learning model monitoring apparatus of claim 1, wherein the first importance evaluation unit calculates a Shapley value of the at least one feature for the trained state diagnosis model and evaluates the local importance based on the calculated Shapley value.

3. The learning model monitoring apparatus of claim 1, wherein the second importance evaluation unit evaluates the global importance by averaging a plurality of local importances in the cycles for each of the at least one feature.

4. The learning model monitoring apparatus of claim 1, further comprising a causality evaluation unit configured to evaluate a causal relationship between factors of the trained state diagnosis model,
wherein the factors comprise a state diagnostic result and/or the at least one feature.

5. The learning model monitoring apparatus of claim 4, wherein the causality evaluation unit evaluates a causal relationship between the state diagnostic result and the at least one feature among the factors.

6. The learning model monitoring apparatus of claim 4, further comprising an analysis unit configured to analyze a relationship between a first feature and a second feature,
wherein the causality evaluation unit determines the second feature causing the first feature with a highest global importance among the at least one feature by evaluating a causal relationship between the at least one features.

7. The learning model monitoring apparatus of claim 1, wherein the time series data comprises time series data for at least one of voltage, current, or temperature of the battery.

8. The learning model monitoring apparatus of claim 1, further comprising a preprocessing unit configured to extract the plurality of sub-time series data by classifying the cycles based on whether the battery is charging or discharging in the time series data.

9. A learning model monitoring method comprising:
acquiring time series data of a battery;
organizing the time series data and extracting at least one feature value corresponding to at least one feature for each of a plurality of sub-time series data corresponding to different cycles;
training a state diagnosis model capable of diagnosing a state of the battery based on the extracted at least one feature value;
evaluating local importance of the at least one feature for the trained state diagnosis model in each cycle; and
evaluating global importance of the at least one feature for the trained state diagnosis model based on the local importance.

10. The learning model monitoring method of claim 9, wherein the evaluating of the local importance comprises:
calculating a Shapley value of the at least one featured for the trained state diagnosis model; and
evaluating the local importance based on the calculated Shapley value.

11. The learning model monitoring method of claim 9, where the evaluating of the global importance comprises evaluating the global importance by averaging a plurality of local importances of the cycles for each of the at least one feature.

12. The learning model monitoring method of claim 9, further comprising evaluating a causal relationship between factors of the trained state diagnosis model,
wherein the factors comprise a state diagnostic result and/or the at least one feature.

13. The learning model monitoring method of claim 12, wherein the evaluating of the causal relationship comprises evaluating a causal relationship between the state diagnostic result and the at least one feature among the factors.

14. The learning model monitoring method of claim 12, further comprising analyzing a relationship between a first feature and a second feature,
wherein the evaluating of the causal relationship comprises determining the second feature causing the first feature with a highest global importance among the at least one feature by evaluating a causal relationship between the at least one features.

15. The learning model monitoring method of claim 9, further comprising extracting the plurality of sub-time series data by classifying the cycles based on whether the battery is charging or discharging in the time series data.
